**Europäisches Patentamt**

(19) **European Patent Office**

**Office européen des brevets**

(11) Veröffentlichungsnummer: **0 015 438**
**A1**

## (12) EUROPÄISCHE PATENTANMELDUNG

(21) Anmeldenummer: **80100826.9**

(22) Anmeldetag: **19.02.80**

(51) Int. Cl.³: **H 03 K 17/96**, G 06 F 3/02, G 06 F 3/14, G 09 F 9/00

(30) Priorität: **28.02.79 DE 2907811**

(43) Veröffentlichungstag der Anmeldung: **17.09.80** Patentblatt 80/19

(84) Benannte Vertragsstaaten: **BE FR GB IT NL**

(71) Anmelder: **Agfa-Gevaert AG, Camera-Werk Patent- und Lizenzwesen Postfach, D-8000 München 90 (DE)**

(72) Erfinder: **Paulus, Rudolf, Iltisstrasse 28, D-8000 München 82 (DE)**
Erfinder: **Mischo, Klaus, Rudolf-Schneider-Weg 10, D-8000 München 83 (DE)**

(54) Funktionseingabeeinheit mit Berührungstasten.

(57) In einer Funktionseingabeeinheit mit Berührungstasten (5a–5d), bei denen bei Berührung eine Schaltfunktion ausgelöst wird, sind auf der dem Benutzer zugewandten Seite eines transparenten Trägers (4) transparente Kontaktflächen (5) aufgebracht, während an der gegenüberliegenden Seite eine ggf. austauschbare Anzeigeeinheit (2) angeordnet ist. Vorzugsweise sind einzelne Bereiche (2a–2d) der Anzeigeeinheit (2) den Berührungstasten (5a–5d) örtlich zugeordnet. Einzelne Kontaktflächen können zur variablen Ausbildung von Tastengruppen entsprechend den jeweiligen Bedürfnissen frei verschaltbar sein.

EP 0 015 438 A1

CW 2229.7 PU/MU

CAMERA-WERK MÜNCHEN
PATENTABTEILUNG
2 6. 2. 1979
10-re-hh

- 1 -

## Funktionseingabeeinheit mit Berührungstasten

Die Erfindung bezieht sich auf eine Funktionseingabeeinheit mit Berührungstasten, bei denen bei Berührung zweier voneinander isolierter Kontaktflächen deren Übergangswiderstand verringert und hierdurch eine Schaltfunktion ausgelöst wird.

Bei diesen Berührungstasten sind die bei Tastaturen wichtigen Kriterien wie geringer Tastendruck, Funktionssicherheit sowie niedrige Kosten in günstiger Weise erfüllt. Nachteilig hierbei ist jedoch, daß die geräteseitige Bestätigung der eingegebenen Funktion, die meist durch Aufleuchten einer Lampe erfolgt, auf den Bereich zwischen den beiden Kontaktflächen oder auf den Bereich außerhalb der Taste beschränkt ist. Eine beliebig gestaltete Leuchtbestätigung ist am Ort der Taste nicht möglich. Darüber hinaus ist man bei der Funktionskennzeichnung der Taste auf das Umfeld der Taste angewiesen, so daß auch hierdurch die gestalterische Freiheit eingeschränkt wird.

...

Der Erfindung liegt daher die Aufgabe zugrunde, eine Funktionseingabeeinheit mit Berührungstasten zu schaffen, welche bei der Gestaltung des Tastenfeldes unter Berücksichtigung von ergonomischen, gestalterischen und technischen Gesichtspunkten größtmögliche Freiheit läßt.

Erfindungsgemäß ist hierzu vorgesehen, daß auf der dem Benutzer zugewandten Seite eines transparenten, isolierenden Trägers transparente, elektrisch leitende Kontaktflächen aufgebracht sind und daß an der dem Benutzer abgewandten Seite des Trägers eine Anzeigeeinheit angeordnet ist. Durch die erfindungsgemäße transparente Ausgestaltung der Berührungstasten ist es möglich, die Anzeigeeinheit durch die Berührungstasten hindurch zu betrachten, so daß bei der Gestaltung der Anzeigeeinheit auf die Anwesenheit der Berührungstasten keinerlei Rücksicht genommen zu werden braucht.

Die Bereiche der Anzeigeeinheit sind vorzugsweise einzelnen Tastenfunktionen zugeordnet, insbesondere derart, daß sie, in Blickrichtung des Benutzers gesehen, hintereinander liegen, so daß die transparente Berührungstaste in direktem örtlichem Zusammenhang mit der Kennzeichnung der jeweiligen Tastenfunktion und bedarfsweise auch mit der Funktionsbestätigung steht.

Gemäß einem weiteren vorteilhaften Merkmal der Erfindung ist die Anzeigeeinheit auswechselbar. Hierdurch kann dieselbe

...

Tasteneinheit je nach Bedarf für unterschiedliche Funktionen verwendet werden. Weiterhin ist die Anpassung der Anzeigeeinheit, z. B. einer Schrifttafel, an die jeweiligen Erfordernisse ohne weiteres möglich. So kann z. B. auf einfachste Weise ein Gerät an fremde Sprachen angepaßt werden, in dem unter Beibehaltung der transparenten Berührungstasteneinheit lediglich die dahinter befindliche Funktionsbeschriftung ausgetauscht wird.

Vorzugsweise sind auf dem isolierenden Träger die Tasten in Form einer Tastenmatrix aufgebracht. Die einzelnen Kontaktflächen können erfindungsgemäß zum Erzeugen großflächiger Berührungstasten parallelgeschaltet sein, wodurch sich ein erhöhter Bedienungskomfort ergibt, da der Benutzer nunmehr beim Auslösen des Kontaktes nicht mehr auf eine einzige kleine Kontaktstelle beschränkt ist.

Besonders vorteilhaft ist es, wenn gemäß einem weiteren Erfindungsmerkmal zumindest ein Teil der Kontaktflächen zum Erzeugen variabler Tastengruppen frei verschaltbar ist. Die elektrische Auswertung erfolgt hierbei außerhalb des panel. Hierbei werden nur gewünschte Kontaktbahnen abgegriffen und bedarfsweise parallelgeschaltet, während nicht genutzte Bahnen freibleiben. Auf diese Weise kann mit einem in Großserie hergestellten Standard-panel durch gerätespezifische Anpassung der äußeren Abmessungen auf einfachste Weise eine den jeweiligen Erfordernissen angepaßte Eingabefläche erzeugt werden.

0015438

Des weiteren ist bei schon festgelegter Größe der Eingabefläche eine Hinzunahme von neuen Funktionen bzw. ein Wegfall
von nicht mehr benötigten Funktionen durch Verkleinern bzw.
Vergrößern der funktionsspezifischen Tastenteilflächen unter
gleichzeitigem Ändern der Kontaktauswertung und der Tastenbeschriftung möglich.

Mit dieser erfindungsgemäßen Eingabeeinheit steht erstmals
ein Standard-Baustein zur Verfügung, der zu außerordentlich
niedrigen Kosten produziert werden kann, der während der gesamten Geräteentwicklung und Gerätefertigungsphase flexibel
an geänderte Funktionseingabeverhältnisse angepaßt werden
kann und der aufgrund seiner universellen Verwendbarkeit in
einem breiten Gerätespektrum einsetzbar ist.

Bei zunehmender technischer Kompliziertheit der Geräte mit
wachsender Zahl der Einstellmöglichkeiten wird die Übersichtlichkeit der Bedienung immer mehr erschwert, da für einen bestimmten Betriebszustand Teile der Bedienungselemente nicht
benötigt werden, während in einem zweiten Betriebszustand
wiederum ein anderer Teil der Eingabetasten überflüssig ist.
So ist z. B. bei einem radio recorder nach dem Einschalten
als erster Bedienungsvorgang primär die Wahl des Senders von
Interesse, als zweiter die Einstellung der Lautstärke, Klangfarbe, Balance usw., zur anschließenden Aufnahme eines
gesendeten Stückes interessieren dann nur noch die den Tonträger beeinflussenden Eingaben wie z. B. Bandtransport vorwärts, Bandtransport rückwärts, Aussteuerungspegel, Startaufnahme, Stop usw.. Mit der herkömmlichen Eingabemethode
besitzt solch ein Gerät eine Vielzahl von Eingabemöglichkeiten, die zum überwiegenden Teil nicht gleichzeitig benutzt
werden können und daher, auf einen bestimmten Funktionszustand bezogen, zu einem großen Teil überflüssig sind, verwirren und stören. Die Vielzahl der Tasten benötigt eine entsprechend große Eingabefläche am Gerät. Das führt oft zu aufgeblähten Geräteabmessungen, wie sie von den im Gerät befindlichen Bauteilen nicht benötigt würden. So werden z. B. bei
manchen Taschenrechnern den Tasten Zweit- oder gar Drittfunktionen zugeordnet, um übergroße Gehäuse zu vermeiden.

Erfindungsgemäß wird daher eine Ein- und Ausgabeeinheit vorgeschlagen, die ein Display mit numerischer, alphanumerischer
oder grafischer Anzeige und eine vom Benutzer ausgesehen vor
der Displayfläche angeordnete Tastatur, bestehend aus transparenten Berührungstasten, sogenannten touch panel, aufweist.
Die transparenten Berührungstasten können vorteilhafterweise
direkt auf der Display-Fläche aufgebracht sein, um hierdurch
einen besonders einfachen Aufbau der Einheit zu erreichen.
Die Display-Einrichtung wird vorzugsweise von einer LCD-
Matrix gebildet.

Hierdurch wird auf besonders übersichtliche und einfache
Weise ein interaktiver Gerätebetrieb möglich, wobei der Eingabebereich und der Anzeigebereich auf einer einzigen gemeinsamen Fläche angeordnet sind, so daß sich eine äußerst kompakte Bauweise der Ein- und Ausgabeeinheit ergibt.

Mit der vorgeschlagenen Ein- und Ausgabeeinheit ist es nun möglich, daß das Display wahlweise verschiedene Eingabefunktionen anzeigt oder auch Ergebnis-Anzeigefunktionen übernimmt. Es ist somit eine multifunktionale Anzeige vorhanden, die wechselnde Tastenfunktions-Definition einerseits sowie Ergebnismitteilung andererseits ermöglicht.

Weitere Vorteile der Erfindung sind den übrigen Unteransprüchen im Zusammenhang mit der nachfolgenden Beschreibung zu entnehmen, in der mehrere Ausführungsbeispiele der Erfindung anhand der Zeichnung näher erläutert sind. In der Zeichnung zeigen in schematischer Darstellung

Figur 1    eine Funktionseingabeeinheit mit touch panel, austauschbarer Tastenbeschriftungskarte und Tastenbeleuchtungseinrichtung,

Figur 2    ein touch panel für eine Einheit gemäß Figur 1 mit variabel verschaltbaren Kontaktflächen,

Figuren 3 die Ansicht jeweils einer Funktionseingabeeinheit
bis 5    mit jeweils gleichem touch panel, jedoch unterschiedlicher Tastenauswahl und unterschiedlicher Kontaktflächenverschaltung,

Figur 6    die Aufsicht auf ein touch panel mit einer Tastenmatrix,

Figur 7    einen Schnitt durch ein touch panel gemäß Figur 6 entlang der Linie VII-VII,

Figur 8    eine weitere Ausführungsform einer Berührungstastenmatrix auf einem touch panel,

Figur 9    einen Schnitt durch das touch panel gemäß Figur 8 entlang der Linie IX-IX,

Figur 10   eine Ein- und Ausgabeeinheit mit einer Kathodenstrahlröhre als Display,

Figur 11   eine Ein- und Ausgabeeinheit mit einem LCD-Element als Display und

Figur 12   eine Tischuhr mit über den Ziffern angeordneten Berührungstasten.

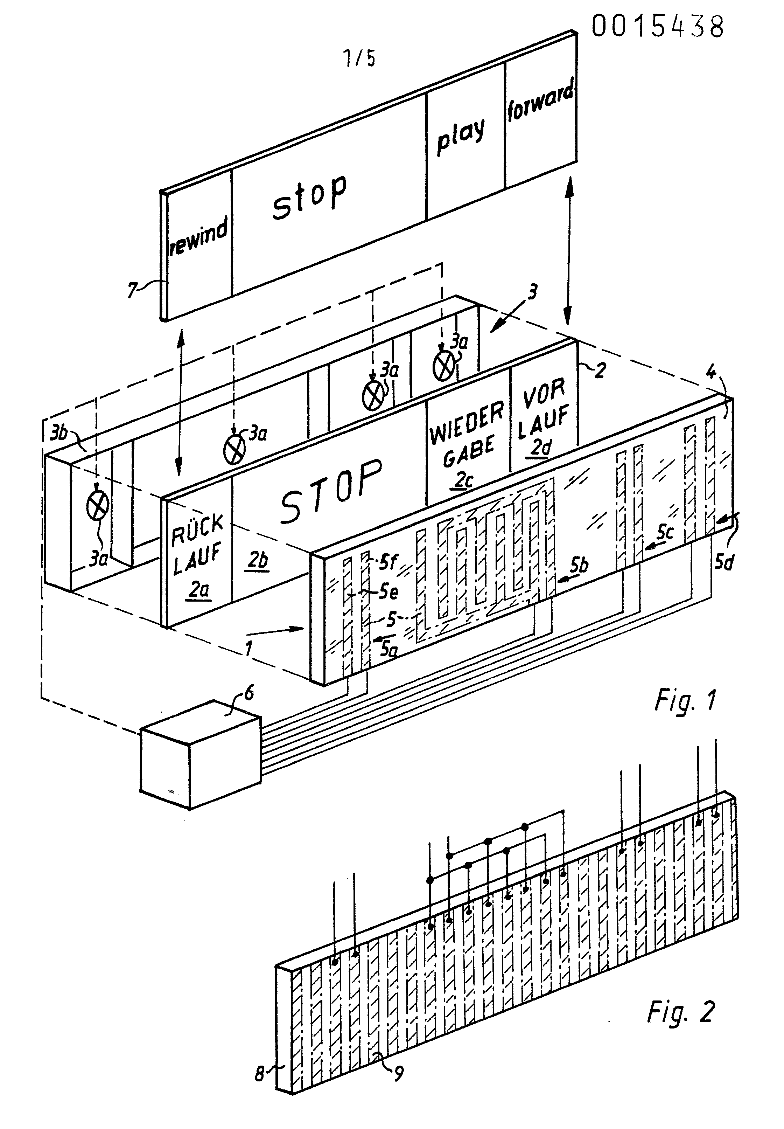

Figur 1 zeigt die einzelnen Elemente einer Funktionseingabeeinheit in Explosionsdarstellung. Sie umfaßt ein touch panel
1, eine Tastenbeschriftungskarte 2 und eine Tastenbeleuchtungseinrichtung 3. Die drei Bauteile werden in einem nicht
dargestellten Rahmen zusammengehalten.

Das touch panel umfaßt einen optisch transparenten, elektrisch isolierenden Träger 4 aus z. B. Glas, auf den Kontaktflächen 5 aus optisch transparentem, elektrisch leitendem und wischfestem Material, z. B. aus Indiumoxyd ($In_2O_3$) aufgebracht sind. Durch Berührung zweier benachbarter Kontaktflächen, z. B. 5 e, 5 f, wird der Übergangswiderstand zwischen diesen beiden Kontaktflächen verringert, so daß in einer geräteseitigen Steuereinrichtung 6 eine Schaltfunktion erzeugt wird. Die Kontaktverbindungen der Steuereinrichtung mit den Kontaktflächen 5 sind hier nicht näher dargestellt, sie können über Federzungen, Ringleitelastomer oder andere bekannte Mittel erfolgen.

Die Kontaktflächen befinden sich auf der dem Benutzer zugewandten Seite des Trägers 4. Vom Benutzer aus gesehen hinter dem Träger 4 ist eine Tastenbeschriftungskarte 2 vorgesehen, wobei die einzelnen Beschriftungsfelder 2 a bis 2 d hinter den entsprechenden Tastengruppen 5 a bis 5 d angeordnet sind. Die Tastenbeschriftungskarte 2 selbst ist opak, so daß ihre Vorderseite von den rückwärtig angeordneten Lampen 3 a der Beleuchtungseinrichtung 3 selektiv erhellt werden kann. Ein Abblendrahmen 3 b sorgt dafür, daß jeweils nur das gewünschte Beschriftungsfeld 2 a bis 2 d beleuchtet wird. Die selektive Ansteuerung der Lampen 3 a erfolgt gleichzeitig mit dem Betätigen der jeweiligen Berührungstaste 5 a bis 5 d über die Steuereinrichtung 6.

Die in Figur 1 dargestellte Eingabeeinheit ist beispielsweise ausgestaltet als Eingabeeinheit für ein Magnetband-Wiedergabegerät. Den vier Tasten 5 a bis 5 d sind die Funktionen Vorlauf, Rücklauf, Stop und Wiedergabe zugeordnet. Entsprechende Beschriftungen befinden sich auf den Feldern 2 a bis 2 d der Tastenbeschriftungskarte 2. Soll nun das gleiche Gerät in ein fremdsprachiges Land geliefert werden, so wird die Tastenbeschriftungskarte 2 aus der Einheit herausgezogen und gegen eine Tastenbeschriftungskarte 7 mit fremdsprachiger Aufschrift ausgetauscht. Trotz der Ortskopplung von Taste und Funktionsbeschriftung ist somit aufgrund der Transparenz der Taste und aufgrund der Austauschbarkeit der Tastenbeschriftungskarte auch eine nachträgliche Anpassung der Tastenbeschriftung ohne weiteres möglich.

Die Berührungstaste 5 b in Figur 1 ist durch Parallelschaltung von Kontaktflächen großflächig ausgestaltet. Solche großflächigen Tasten sind äußerst benutzerfreundlich und sind auch bei relativ kleinem Platzangebot möglich, nachdem aufgrund der Transparenz der Tasten die Tastenbeschriftung nicht mehr im Umfeld der Taste, sondern direkt hinter der Taste angeordnet ist, so daß für die Beschriftung selbst kein Platz benötigt wird.

Alternativ zur dargestellten Ausgestaltung der Anzeigeeinheit als auswechselbare Tastenbeschriftungskarte kann die Tastenbeschriftung beispielsweise auch auf die Rückseite des Trägers 4 aufgeklebt oder aufgedruckt sein.

...

Eine Vereinfachung bei der Herstellung des transparenten touch panel ergibt sich, wenn auf dem transparenten Träger 8 ein regelmäßiges Leiterbahnmuster von Kontaktflächen 9 erzeugt wird, dessen elektrische Auswertung außerhalb des touch panel erfolgt. Ein solches panel ist in Figur 2 dargestellt, wobei die Verschaltung so ausgeführt wurde, daß das Tastenmuster dem Tastenmuster des touch panel 1 entspricht.

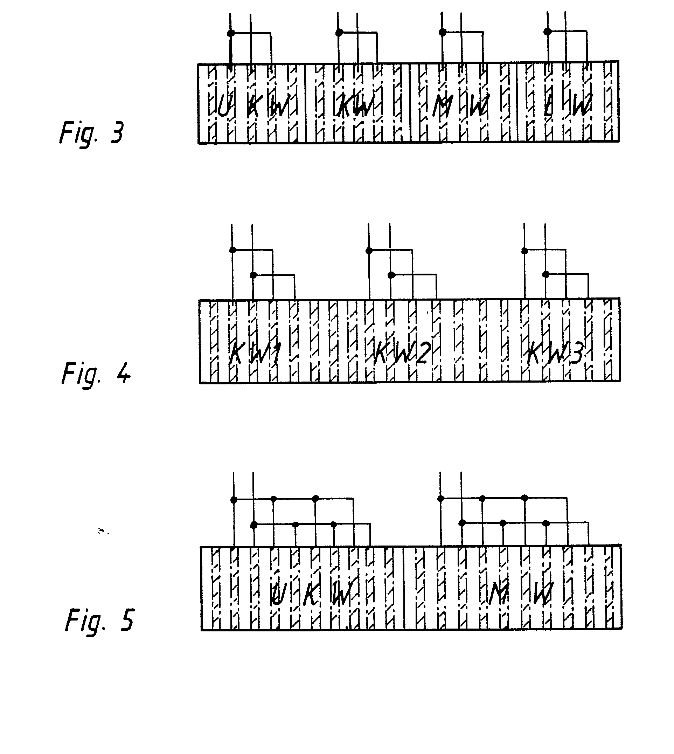

In den Figuren 3 bis 5 ist ein weiteres Beispiel einer Funktionseingabeeinheit dargestellt, wobei unter Verwendung desselben touch panel durch unterschiedliche Verschaltung der Kontaktflächen 9 und mit jeweils unterschiedlicher Tastenbeschriftungskarten für verschiedene Anwendungen verschieden große Tastenflächen entstehen. Bei Verwendung desselben Standard-panels ist somit eine Hinzunahme von Funktionen bzw. ein Wegfall von nicht mehr benötigten Funktionen durch Verkleinern bzw. Vergrößern der funktionsspezifischen Tastenteilflächen unter gleichzeitigem Ändern der Kontaktauswertung und der Tastenbeschriftung möglich.

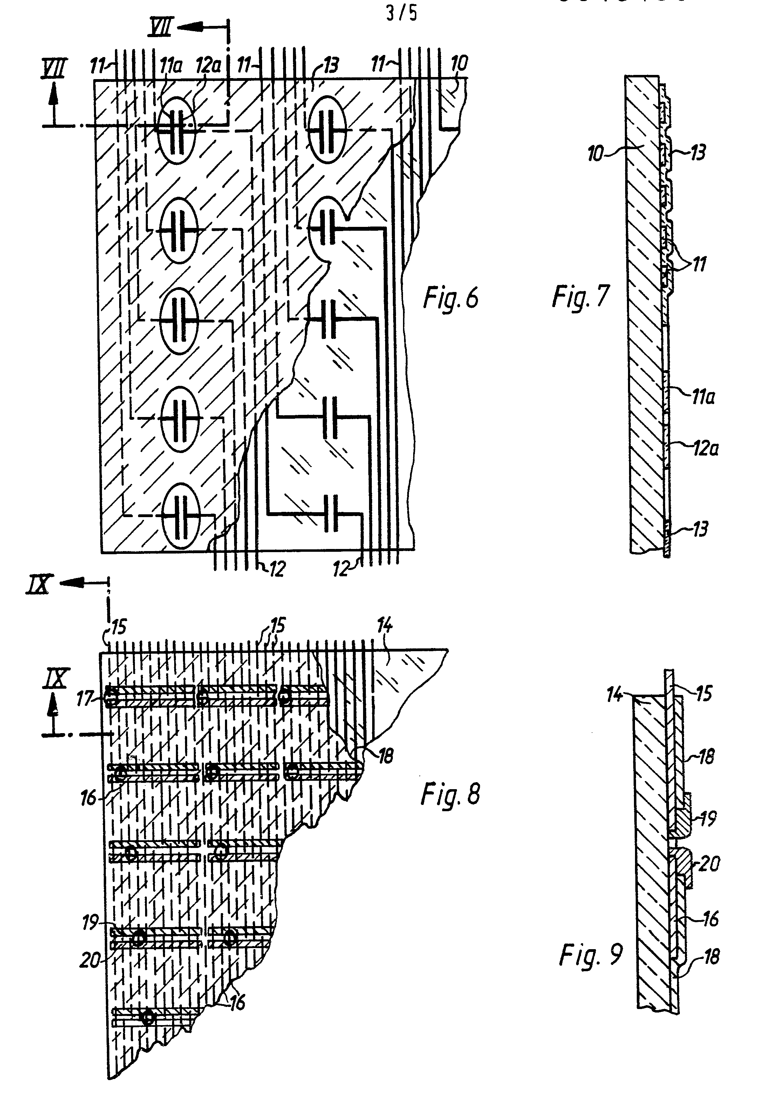

Anstelle des in den Figuren 1 bis 5 dargestellten Leiterbahnenmusters kann in vielen Anwendungsfällen vorteilhafterweise eine matrixartige Anordnung der Berührungstasten zweckmäßig sein, wie sie in den Figuren 6 bis 9 dargestellt ist. Wiederum ist ein transparenter, elektrisch isolierender Träger 10 aus z. B. Glas vorgesehen, auf den Leiterbahnen 11, 12 aus transparentem, elektrisch leitendem Material, beispielsweise

...

wiederum aus Indiumoxyd, aufgebracht, z. B. aufgedampft sind.
Über die gesamte panel-Fläche, also auch über die Leiterbahnen, ist eine einheitliche transparente, elektrisch isolierende Schicht 13 aus z. B. Quarz aufgedampft, die lediglich
im Bereich der Tasten 11 a, 12 a unterbrochen ist, um eine
Tastenberührung zu ermöglichen.

Eine andere Ausgestaltung der Tastenmatrix ist in den Figuren 8 und 9 dargestellt. Hier sind auf dem transparenten Träger 14 parallele Kontaktbahnenpaare 15, 16 vorgesehen, die in
den durch die Kreise 17 angedeuteten Bereichen, die matrixförmig über das gesamte  panel verteilt sind, jeweils einmal
unterbrochen sind. Über das gesamte panel ist eine transparente Isolierschicht 18 gezogen, die im Bereich der Kreise 17
unterbrochen ist. Zwei senkrecht zur Richtung der Leiterbahnen
15, 16 auf die transparente Schutzschicht 18 aufgebrachte
transparente, elektrisch leitfähige Kontaktstreifen 19, 20
sind im Bereich des Kreises 17 mit jeweils einer der Leiterbahnen 15, 16 elektrisch verbunden und dienen als eigentliche Berührungstaste. Jedem der Bereiche 17 ist eine eigene
Taste 19, 20 zugeordnet.

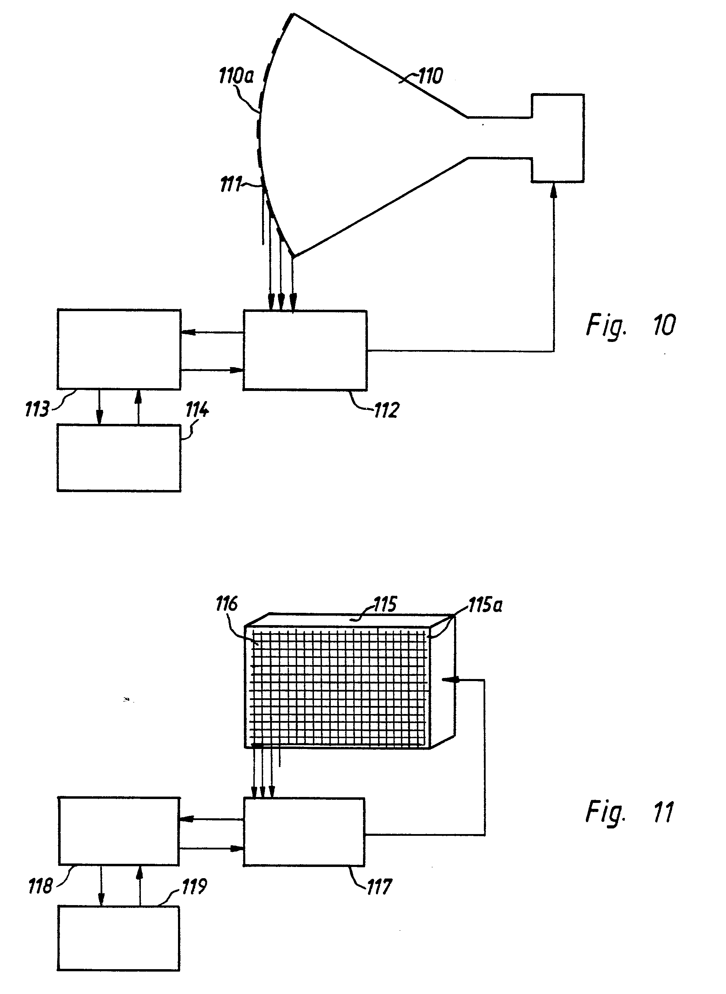

In Figur 10 ist mit der Bezugsziffer 110 eine Kathodenstrahlröhre bezeichnet, an deren dem Benutzer zugewandten Display-
Fläche 110 a eine transparente Berührungstastenmatrix 111 aufgebracht ist. Über einen Programmspeicher 112 werden die vom
Benutzer in die Tastenmatrix eingegebenen Befehle verarbeitet. Die entsprechenden Ergebnisfunktionen werden wiederum

...

der Kathodenstrahlröhre zur entsprechenden optischen Darstellung zugeführt. Weiterhin kann der Programmspeicher 112 mit einer Gerätesteuereinrichtung 113 zusammenwirken, die ihrerseits die über die Berührungstastenmatrix 111 eingegebenen Anweisungen durchführt bzw. bestimmte Betriebszustände des Gerätes 114 über den Programmspeicher 112 in der Kathodenstrahlröhre 110 optisch anzeigt.

In Figur 11 ist als Display-Einheit ein LCD-Element 115 vorgesehen, auf dessen Display-Fläche 115 a wiederum eine transparente Berührungstastenmatrix 116 aufgebracht ist. Mit 117 ist wiederum ein Programmspeicher, mit 118 eine Gerätesteuereinrichtung und mit 119 ein Gerät bezeichnet.

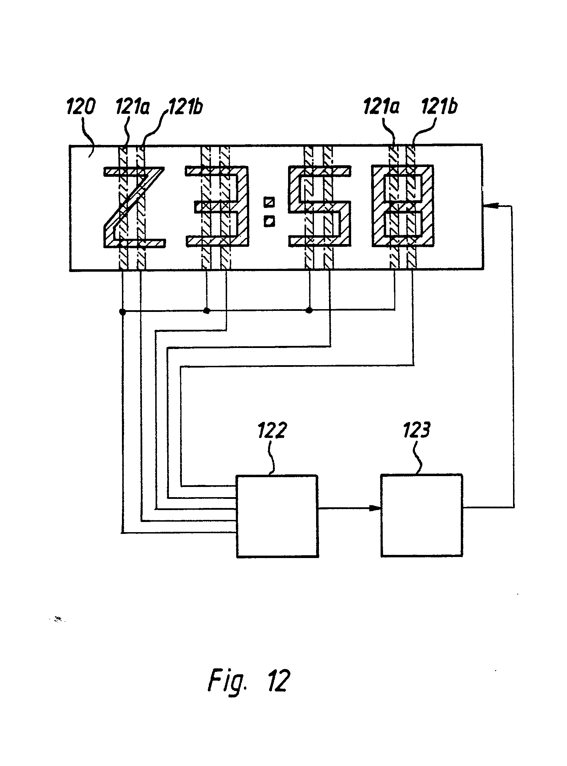

Figur  12 zeigt in schematischer Darstellung eine digitale elektronische Tischuhr. Eine solche Tischuhr umfaßt im allgemeinen zwei zweistellige Stunden- und Minutenanzeigen, die durch einen im Sekundentakt blinkenden Doppelpunkt getrennt sind. Die Einstellung der Zeit erfolgt üblicherweise über Tasten für Stunden- und Minuteneinstellung und weiteren Tasten für Schnell- und Langsamdurchlauf der Ziffern. Bei der in Figur 12 dargestellten Tischuhr kann die Zeiteinstellung jedoch wesentlich einfacher und schneller durchgeführt werden. Hierzu ist auf der Display-Fläche der Anzeigeeinheit 120 über jeden der Ziffern jeweils eine Berührungstaste 121 a, 121 b angeordnet. Für die Dauer der Berührung der Tasten wird im Impulsgenerator 122 eine Impulsfolge erzeugt, die über die

...

Steuereinrichtung 123 ein Fortschalten derjenigen Ziffer bewirkt, deren zugeordnete Berührungstaste berührt wurde.


Hierzu 5 Blatt Zeichnungen

CW 2229.7 PU/MU — 14 —

## Ansprüche

1. Funktionseingabeeinheit mit Berührungstasten, bei denen bei Berührung zweier voneinander isolierter Kontaktflächen deren Übergangswiderstand verringert und hierdurch eine Schaltfunktion ausgelöst wird, <u>dadurch gekennzeichnet,</u> daß auf der dem Benutzer zugewandten Seite eines transparenten isolierenden Trägers (4, 110 a) transparente, elektrisch leitende Kontaktflächen (5, 111) aufgebracht sind, und daß an der dem Benutzer abgewandten Seite des Trägers eine Anzeigeeinheit (2, 3, 110) angeordnet ist.

2. Funktionseingabeeinheit nach Anspruch 1, dadurch gekennzeichnet, daß Bereiche (2 a - 2 d) der Anzeigeeinheit (2) einzelnen Tastenfunktionen zugeordnet sind.

3. Funktionseingabeeinheit nach Anspruch 2, dadurch gekennzeichnet, daß einzelne Bereiche (2 a - 2 d) der Anzeigeeinheit (2) einzelnen Berührungstasten (5 a - 5 d) örtlich so zugeordnet sind, daß sie, in Blickrichtung des Benutzers gesehen, hintereinander liegen.

...

4.   Funktionseingabeeinheit nach einem der vorhergehenden
     Ansprüche, dadurch gekennzeichnet, daß die Anzeigeeinheit (2, 7) auswechselbar ist.

5.   Funktionseingabeeinheit nach einem der vorhergehenden
     Ansprüche, dadurch gekennzeichnet, daß auf dem isolierenden Träger (10) eine Matrix von Berührungstasten
     (11 a, 12 a) aufgebracht ist.

6.   Funktionseingabeeinheit nach einem der vorhergehenden
     Ansprüche, dadurch gekennzeichnet, daß einzelne Kontaktflächen (9) zum Erzeugen großflächiger Berührungstasten parallelgeschaltet sind.

7.   Funktionseingabeeinheit nach einem der vorhergehenden
     Ansprüche, dadurch gekennzeichnet, daß zumindest ein
     Teil der Kontaktflächen (9) zum Erzeugen variabler
     Tastengruppen frei verschaltbar ist.

8.   Funktionseingabeeinheit nach einem der vorhergehenden
     Ansprüche, dadurch gekennzeichnet, daß die Berührungstasten (5 a - 5 d) Leuchtmittel (3 a) zum selektiven
     Beleuchten der den jeweiligen Tastenfunktionen zugeordneten Bereichen (2 a - 2 d) der Anzeigeeinheit (2)
     steuern.

                                                    ...

9.   Funktionseingabeeinheit nach einem der vorhergehenden
     Ansprüche, dadurch gekennzeichnet, daß die Anzeigeeinheit von einer elektrisch ansteuerbaren Display-Einrichtung (110, 115) gebildet wird.

10.  Funktionseingabeeinheit nach Anspruch 9, dadurch gekennzeichnet, daß die elektrisch leitenden Kontaktflächen
     (111, 116) auf der Anzeigefläche (110 a, 115 a) der
     Display-Einrichtung (110, 115) aufgebracht sind.

11.  Funktionseingabeeinheit nach Anspruch 9 oder 10, dadurch
     gekennzeichnet, daß die Display-Einrichtung von einer
     LCD-Matrix (115) gebildet wird.

12.  Ein- und Ausgabeeinheit, gekennzeichnet durch ein Display (110, 115) mit numerischer, alphanumerischer oder
     grafischer Anzeige und einer vom Benutzer aus gesehen
     vor der Display-Fläche (110 a, 115 a) angeordneten
     Tastatur, bestehend aus transparenten Berührungstasten
     (touch panel).

13.  Ein- und Ausgabeeinheit nach Anspruch 12, dadurch gekennzeichnet, daß die transparenten Berührungstasten
     auf der Display-Fläche (110 a, 115 a) aufgebracht sind.

14.  Ein- und Ausgabeeinheit nach Anspruch 12 oder 13, dadurch gekennzeichnet, daß zwischen Display und Tastatur
     eine Steuereinheit mit einem Programmspeicher (112)
     geschaltet ist.

                                                    ...

0015438

rewind stop play forward

7

3

3a

3a

3b

3a

STOP

WIEDER GABE 2c

VOR LAUF 2d

2

4

3a

RÜCK LAUF 2a

2b

5f

5e

5

5a

5b

5c

5d

1

6

**Fig. 1**

8

9

**Fig. 2**

Fig. 3

Fig. 4

Fig. 5

Fig. 6

Fig. 7

Fig. 8

Fig. 9

110a
110
111

Fig. 10

113    114    112

116    115    115a

Fig. 11

118    119    117

Fig. 12

**Europäisches Patentamt**

**EUROPÄISCHER RECHERCHENBERICHT**

0015438

Nummer der Anmeldung

EP 80 10 0826

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 3 207 905 (T.E. BRAY) <br> * Spalte 1, Zeilen 9 bis 11; <br> Spalte 2, Zeile 66 bis Spalte 3, Zeile 9; Spalte 4, Zeilen 44 bis 48; Fig. 5; <br> Spalte 7, Zeile 68 bis Spalte 8, Zeile 51 * <br> -- | 1-3, 6,8, 9,12 |
| P,X | Patents Abstracts of Japan <br> Band 3, Nr. 30 (E-97), 13. März 1979, Seite 132 E97 <br> * Zusammenfassung und Zeichnung * <br> & JP - A - 54 - 8925 <br> -- | 1,5, 9,12, 14 |
| X | US - A - 3 482 241 (E.A. JOHNSON) <br> * Spalte 2, Zeilen 1 bis 3 und Zeilen 32 bis 36; Fig. 4; <br> Spalte 4, Zeile 1 bis Spalte 5, Zeile 12 * <br> -- | 1,5, 9 |
| A | DE - A - 2 200 918 (NORDDEUTSCHE MENDE RUNDFUNK KG) <br> * Fig. 1 * <br> -- | 1 |
| A | US - A - 3 701 869 (JACOB et al.) <br> * ganzes Dokument * <br> -- <br> ./.. | |

**KLASSIFIKATION DER ANMELDUNG (Int.Cl.3)**

H 03 K 17/96
G 06 F 3/02
G 06 F 3/14
G 09 F 9/00

**RECHERCHIERTE SACHGEBIETE (Int. Cl.3)**

G 06 F 3/02
G 06 F 3/14
G 06 K 15/20
G 09 F 9/00
H 03 K 17/96

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 20-05-1980 | ARENDT |

EPA form 1503.1   06.78

Europäisches
Patentamt

**EUROPÄISCHER RECHERCHENBERICHT**

00.15438
Nummer der Anmeldung

EP 80 10 0826
- Seite 2 -

| | **EINSCHLÄGIGE DOKUMENTE** | | **KLASSIFIKATION DER ANMELDUNG (Int.Cl.3)** |
|---|---|---|---|
| Kategorie | Kennzeichnung des Dokuments mit Angabe, soweit erforderlich, der maßgeblichen Teile | betrifft Anspruch | |
| A | US - A - 3 757 322 (BARKAN et al.) <br> * ganzes Dokument * <br><br> -- | | |
| A | ELEKTOR, November 1971 <br> Canterbury <br> Seiten 1136 bis 1138 <br> * ganzes Dokument * <br><br> ---- | | **RECHERCHIERTE SACHGEBIETE (Int. Cl.3)** |